# DEMANDE DE BREVET EUROPEEN

(11) **EP 4 553 186 A1**
(43) Date de publication de la demande: **14.05.2025**
(21) Numéro de dépôt: 23209154.6
(22) Date de dépôt: 10.11.2023
(51) Int. Cl.: C23C 14/00, C23C 14/02, C23C 14/06, C23C 14/08, C23C 14/34, C23C 14/14, C23C 16/455, G04B 19/12

(54) **PROCÉDÉ DE DÉCORATION DE COMPOSANTS HORLOGERS**

(71) Demandeur: The Swatch Group Research and Development Ltd, 2074 Marin (CH)
(72) Inventeur: SPASSOV, Vladislav, 1788 Praz (CH); CURCHOD, Loïc, 1004 Lausanne (CH); MORADI, Mina, 4600 Olten (CH); SPRINGER, Simon, 3007 Bern (CH)
(74) Mandataire: ICB SA

(57) **Abrégé**

L'invention concerne un procédé de décoration d'un composant horloger avec un revêtement blanc. Le procédé comprend la préparation du composant horloger, le dépôt dans une enceinte de déposition d'une couche d'accroche métallique sur tout le composant horloger via un dépôt physique en phase vapeur, le dépôt d'une couche diffusante en aluminium sur tout le composant sous un flux d'un gaz réactif de sorte que la couche d'aluminium se dépose sous la forme d'une structure cristalline à facettes, via un dépôt physique en phase vapeur, la réduction ou l'arrêt du flux du gaz réactif lorsque la couche diffusante a atteint l'épaisseur souhaitée afin de terminer la couche par une fine couche d'aluminium pur, et le dépôt d'une couche de protection transparente via un dépôt de couches minces atomiques.

## Description

### Domaine technique de l'invention

L'invention se rapporte à un revêtement présentant une surface de couleur blanche obtenue par une superposition de couches déposées par PVD et ALD. L'invention concerne également des composants horlogers présentant une telle surface blanche.

### Arrière-plan technologique

L'industrie de l'horlogerie est constamment à la recherche de nouvelles solutions en termes de couleurs et d'apparence. Les articles horlogers de couleur blanche, tels que les cadrans, sont souvent obtenus par l'utilisation de nacres ou l'application d'émail.

La surface des métaux nobles tels que l'argent, le platine, le palladium, ou encore le rhodium permet d'obtenir une apparence blanche éclatante. Il est aussi possible d'obtenir une telle apparence par le dépôt galvanique de ces métaux. Cependant, ils réfléchissent la lumière de manière spéculaire, ce qui confère à la surface de l'article un éclat brillant métallique. Le paramétrage judicieux du procédé de dépôt galvanique permet une diminution du reflet spéculaire de ce revêtement qui devient alors blanc mat.

Les techniques de dépôt physique sous vide en phase vapeur (PVD), par exemple la pulvérisation cathodique, permettent d'obtenir des revêtements minces avec des propriétés prédéfinies sur des substrats de différentes natures et ayant une géométrie complexe (tridimensionnelle).

Plusieurs autres substances naturelles possèdent une couleur blanche. A titre d'exemple, citons des pigments constitués de microparticules de substances minérales telles que l'oxyde de titane ou d'aluminium. Ces particules réfléchissent la lumière de manière diffuse. Ces pigments sont déposés sous forme de peintures, laques ou émaux sur la surface des articles.

Cependant, les revêtements de couleur blanche à base de pigments ne permettent pas d'obtenir une qualité de décor suffisante et satisfaisante. En effet, ils ne permettent pas de conserver l'état de surface du substrat, ni de conserver précisément les détails des décorations. Aussi, les revêtements galvaniques de l'art antérieur présentent un aspect matifiant et sont relativement fragiles.

Il existe donc un besoin de disposer d'un revêtement blanc permettant de conserver l'état de surface du substrat.

### Résumé de l'invention

L'invention a notamment pour objectif de pallier les différents inconvénients des procédés de l'art antérieur.

Plus précisément, un objectif de l'invention est de proposer un procédé de fabrication d'un revêtement blanc « porcelaine » conservant l'état de surface du substrat poli, mat, soleillé ou toute autre décoration, ainsi qu'un composant horloger avec une surface revêtue d'une couche mince de couleur blanche obtenu par ce procédé.

A cet effet, l'invention concerne un procédé de décoration d'un composant horloger avec un revêtement blanc comprenant les étapes suivantes :
- préparation du composant horloger et installation dudit composant dans une enceinte de déposition ;
- dépôt d'une couche d'accroche métallique sur tout le composant horloger via un dépôt physique en phase vapeur ;
- dépôt d'une couche diffusante en aluminium sur tout le composant, sous un flux d'un gaz réactif, tel que la couche déposée contient entre 0.5% et 10% atomiques de ce gaz, de manière que la couche d'aluminium cristallise sous la forme d'une structure cristalline à facettes, via un dépôt physique en phase vapeur ;
- réduire ou couper le flux du gaz réactif lorsque la couche diffusante a atteint l'épaisseur souhaitée afin de terminer l'empilement par une fine couche d'aluminium pur afin d'augmenter au maximum possible la réflectivité de l'empilement obtenue ;
- dépôt d'une couche de protection transparente via un dépôt par la méthode ALD.

Conformément à d'autres variantes avantageuses de l'invention :
- la couche d'accroche est une couche métallique ou d'un alliage métallique qui peut être choisi parmi : l'aluminium, le titane, l'aluminure de titane ou le chrome ;
- la couche d'accroche présente une épaisseur comprise entre 30 nm et 100 nm, de préférence de 50 nm ;
- le procédé comprend une étape supplémentaire de dépôt d'une couche diélectrique après le dépôt de la couche d'accroche ;
- la couche diélectrique présente une épaisseur comprise entre 500 nm et 2000 nm, de préférence de 1000 nm ;
- la couche diélectrique peut être un nitrure, un oxyde ou un oxynitrure d'aluminium, de titane ou de silicium ;
- la couche diffusante présente une épaisseur comprise entre 300 nm et 6000 nm, de préférence entre 1000 nm et 2000 nm, de préférence de 1500 nm ;
- la couche finale d'aluminium pur présente une épaisseur comprise en 50 nm et 400 nm, de préférence de 200 nm ;
- la couche de protection présente une épaisseur comprise entre 0.5 nm et 20 nm, de préférence de 2 nm ;
- la couche de protection peut être choisie parmi les matériaux suivants : dioxyde de titane, oxyde d'aluminium, dioxyde de silicium, nitrure de silicium ;
- la préparation du composant horloger avant le dépôt des couches susmentionnées comprend une étape de lavage ;
- le composant horloger présente des décorations et/ou un état de surface ;
- Le gaz réactif pendant le dépôt de la couche diffusante est de l'oxygène ou de l'azote.

L'invention concerne également un composant horloger présentant un revêtement de couleur blanche obtenu grâce au procédé conforme à l'invention.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- La figure 1 représente schématiquement un substrat avec un revêtement blanc obtenu selon le procédé de l'invention ;
- La figure 2 représente schématiquement les étapes du procédé selon l'invention.

### Description détaillée de l'invention

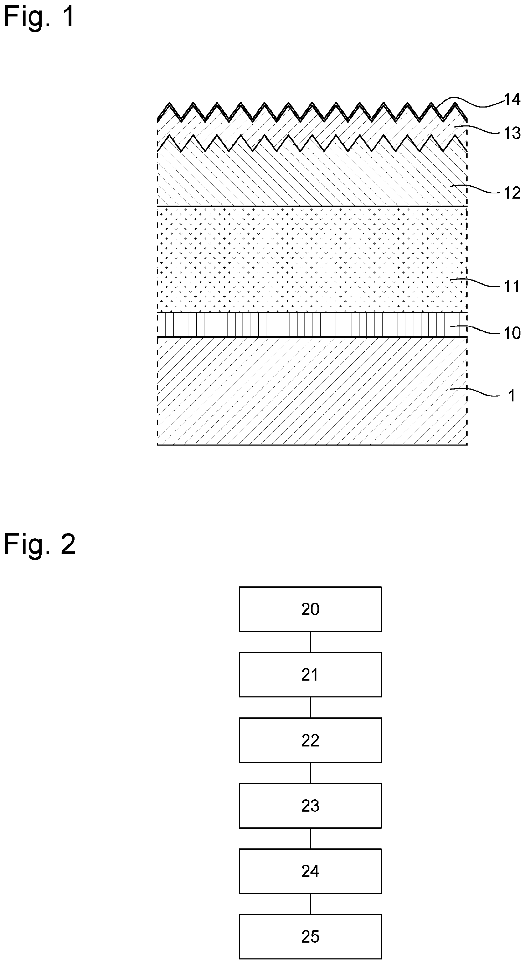

La figure 1 montre une représentation schématique de l'empilement de couches obtenu selon le procédé de l'invention.

Selon un aspect de l'invention, la déposition des revêtements conférant une couleur blanche porcelaine à la surface de l'article décoratif est effectuée par une succession de dépôts PVD et ALD.

De préférence, une enceinte équipée d'un système de pulvérisation de type magnétron est utilisée dans le cadre de l'invention. Ledit système de pulvérisation comprend au moins une cible de pulvérisation en aluminium et des lignes d'injection de gaz permettant de réaliser, à l'intérieur de l'enceinte, une atmosphère contrôlée de type réactif ou inerte. Le fonctionnement de ce dispositif de pulvérisation est décrit dans la littérature scientifique et technique, est connu à l'homme de l'art et il ne sera répété ici que dans les grandes lignes.

Selon l'invention, la surface de couleur blanche est composée d'un revêtement comprenant au moins quatre couches 10, 12, 13 et 14 sur un substrat 1. Afin d'obtenir la structure souhaitée de la couche 12, sur la plupart des substrats une cinquième couche, ceci étant la couche diélectrique 11, est nécessaire.

Le procédé selon l'invention comprend une première étape 20 au cours de laquelle le substrat, ici le composant horloger, est nettoyé par plasma in-situ dans l'enceinte de déposition par polarisation du porte-substrat ou par tout autre méthode connue de l'homme du métier.

Le procédé comprend une deuxième étape 21 de déposition d'une première couche 10 sur le substrat 1, dite couche d'accroche. La couche d'accroche 10 peut être par exemple composée d'aluminium déposé par pulvérisation d'une source d'aluminium en atmosphère neutre, c'est-à-dire sans ajout de gaz réactif. La couche d'accroche peut également être composée de titane, d'aluminure de titane ou encore de chrome et a une épaisseur typiquement entre 30 nm et 100 nm, de préférence 50 nm.

Le procédé comprend une étape optionnelle 22 au cours de laquelle une couche diélectrique 11 est déposée sur la couche d'accroche. L'épaisseur de cette couche est comprise entre 500 nm et 2000 nm, de préférence de 1000 nm, et est composée d'un nitrure, d'un oxyde ou d'un oxynitrure d'aluminium, de titane ou de silicium. Cette couche sert à une nucléation préférable de la couche 12 déposée à l'étape 23.

La troisième étape 23 comprend le dépôt d'une deuxième couche 12. Lors de cette étape, la cathode équipée de la cible d'aluminium est utilisée et un gaz réactif, tel que l'oxygène ou l'azote, est introduit dans l'enceinte et est maintenu à un taux tel qu'il permet d'obtenir une couche d'aluminium dopée à 0.5 à 10% atomiques en gaz réactif, dite couche diffusante 12. La couche diffusante 12 présente une épaisseur comprise entre 300 nm et 6000 nm, de préférence entre 1000 nm et 2000 nm, de préférence de 1500 nm.

Le but de cette troisième étape est d'influencer le dépôt des atomes d'aluminium avec le gaz réactif pour obtenir une couche d'oxyde d'aluminium (ou nitrure d'aluminium dans le cas de l'azote) présentant une structure cristalline à facettes. Une telle couche permet d'obtenir un effet diffusant de la lumière incidente grâce à sa structure cristalline à facettes.

Lors d'une quatrième étape 24, sans éteindre la cathode avec la cible d'aluminium, le flux du gaz réactif est arrêté complètement ou réduit progressivement jusqu'à l'arrêt afin de finir la déposition de la couche diffusante 12 avec une couche d'aluminium pur 13, donc sans dopage de gaz réactif, lorsque l'épaisseur souhaitée de la couche dopée en oxygène est atteinte. La couche finale d'aluminium pur 13 présente une épaisseur comprise en 50 nm et 400 nm, de préférence de 200 nm.

Finalement, au cours d'une cinquième étape 25, une fois que l'épaisseur souhaitée de la couche d'aluminium pur 13 est atteinte, une couche de protection transparente 14 est déposée, de préférence par une méthode de déposition ALD. La couche de protection 14 est composée de l'un des matériaux suivants : le dioxyde de titane, l'oxyde d'aluminium, le dioxyde de silicium, ou de nitrure de silicium.

Ainsi, la couche diffusante 12 couverte de la couche d'aluminium pur 13 réfléchit efficacement la lumière blanche de manière diffuse, conférant une couleur blanche au substrat traité tout en conservant les détails de sa finition de surface et de sa décoration.

Premier exemple de réalisation du procédé selon l'invention :
- le substrat 1 est nettoyé par plasma in-situ dans l'enceinte de déposition par polarisation du porte-substrat ;
- une couche d'accroche d'aluminium est déposée en utilisant une cible d'aluminium sans ajout de gaz réactif ;
- ensuite, sans éteindre la cathode, de l'oxygène est introduit dans l'enceinte de déposition, le flux d'oxygène est choisi et maintenu tel qu'une couche d'oxyde d'aluminium est déposée avec une composition sensiblement proche de celle de l'Al2O3 ;
- ensuite, sans éteindre la cathode, le flux d'oxygène est réduit et maintenu à une valeur qui permet d'obtenir une couche d'aluminium dopée en oxygène formant une structure cristalline facettée diffusante ;
- une fois que l'épaisseur souhaitée de la couche dopée en oxygène est atteinte, sans éteindre la cathode, le flux d'oxygène est arrêté complètement afin de finir la déposition de la couche diffusante avec de l'aluminium pur, sans dopage d'oxygène ;
- une fois que l'épaisseur souhaitée de la couche d'aluminium pur est atteinte, le procédé de déposition PVD est terminé et une couche de protection transparente est déposée par la méthode de déposition ALD.

Deuxième exemple de réalisation du procédé selon l'invention :
- le substrat 1 est nettoyé par plasma in-situ dans l'enceinte de déposition par polarisation du porte-substrat ;
- une couche d'accroche d'aluminium est déposée en utilisant une cible d'aluminium sans ajout de gaz réactif ;
- ensuite, sans éteindre la cathode, un gaz réactif est introduit immédiatement dans l'enceinte, de préférence de l'azote. Le flux d'azote est maintenu à une valeur qui permet d'obtenir une couche d'aluminium dopée en azote formant une structure cristalline diffusante ;
- une fois que l'épaisseur souhaitée de la couche dopée en azote est atteinte, sans éteindre la cathode, le flux d'azote est arrêté progressivement afin de finir la déposition de la couche diffusante avec de l'aluminium pur, sans dopage d'azote ;
- une fois que l'épaisseur souhaitée de la couche d'aluminium pur est atteinte, le procédé de déposition PVD est terminé et une couche de protection transparente est déposée par la méthode de déposition ALD.

Le substrat, ou composant horloger, présente une surface polie, structurée ou décorée, par exemple une surface gravée, perlée, satinée, à côtes de Genève, à colimaçonnage, guillochée, soleillée, ciselée, etc. Le revêtement décoratif blanc de l'invention est suffisamment mince pour permettre de distinguer nettement la décoration et restituer l'état de surface du substrat sous-jacent. On obtient alors une surface blanche d'aspect « porcelaine » et décorée. L'état de surface et la topographie du substrat sont conservés et parfaitement perceptibles/visibles une fois le revêtement déposé. Ainsi, un substrat brillant avec un perlage conservera son aspect brillant et le perlage sera visible. De même, un substrat mat avec des côtes de Genève conservera son aspect mat et les côtes de Genève seront parfaitement visibles.

Le procédé de l'invention permet de déposer un revêtement de couleur blanche « porcelaine » sur tout type de composants horlogers afin d'obtenir des articles décoratifs particulièrement attrayants. On peut par exemple déposer un revêtement blanc par le procédé selon l'invention sur des composants d'habillage interne tels que cadrans, aiguilles, appliques, ponts, platines, barillets, masses oscillantes, etc. Par ailleurs, le procédé selon l'invention peut aussi être appliqué aux articles de bijouterie.

Ainsi, il est possible d'obtenir un composant horloger ayant un aspect blanc porcelaine tout en conservant l'état de surface et les décorations du composant.

## Revendications

1. Procédé de décoration d'un composant horloger (1) avec un revêtement blanc comprenant les étapes suivantes :
- préparation du composant horloger (1) et installation dudit composant dans une enceinte de déposition ;
- dépôt d'une couche d'accroche métallique (10) sur tout le composant horloger via un dépôt physique en phase vapeur ;
- dépôt d'une couche diffusante (12) en aluminium sur tout le composant, sous un flux d'un gaz réactif, le taux du gaz réactif est maintenu de manière à obtenir une couche d'aluminium dopée à 0.5% à 10% atomiques en gaz réactif, de manière que la couche d'aluminium cristallise sous la forme d'une structure cristalline à facettes, via un dépôt physique en phase vapeur ;
- réduire ou couper le flux du gaz réactif lorsque la couche diffusante a atteint l'épaisseur souhaitée afin de terminer la couche diffusante (12) par une fine couche d'aluminium pur (13);
- dépôt d'une couche de protection transparente (14) via un dépôt de couches minces atomiques.

2. Procédé de décoration selon la revendication 1, **caractérisé en ce que** la couche d'accroche (10) est une couche métallique ou d'un alliage métallique choisi parmi : l'aluminium, le titane, l'aluminure de titane ou le chrome.

3. Procédé de décoration selon l'une des revendications 1 ou 2, **caractérisé en ce que** la couche d'accroche (10) présente une épaisseur comprise entre 30 nm et 100 nm, de préférence de 50 nm.

4. Procédé de décoration selon l'une des revendications 1 à 3, **caractérisé en ce qu'**il comprend une étape optionnelle de dépôt d'une couche diélectrique (11) sous un flux d'oxygène ou d'azote après le dépôt de la couche d'accroche.

5. Procédé de décoration selon la revendication 4, **caractérisé en ce que** la couche diélectrique (11) présente une épaisseur comprise entre 500 nm et 2000 nm, de préférence de 1000 nm.

6. Procédé de décoration selon la revendication 4 ou 5, dans lequel la couche diélectrique (11) est un nitrure, un oxyde ou un oxynitrure d'aluminium, de titane ou de silicium.

7. Procédé de décoration selon l'une des revendications 1 à 6, dans lequel la couche diffusante (12) présente une épaisseur comprise entre 300 nm et 6000 nm, de préférence entre 1000 nm et 2000 nm, de préférence de 1500 nm.

8. Procédé de décoration selon l'une des revendications 1 à 7, dans lequel la couche d'aluminium pur (13) présente une épaisseur comprise entre 50 nm et 400 nm, de préférence de 200 nm.

9. Procédé de décoration selon l'une des revendications 1 à 8, dans lequel la couche de protection (14) présente une épaisseur comprise entre 0.5 nm et 20 nm, de préférence de 2 nm.

10. Procédé de décoration selon l'une des revendications 1 à 9, dans lequel la couche de protection (14) est choisie parmi les matériaux suivants : dioxyde de titane, oxyde d'aluminium, dioxyde de silicium, nitrure de silicium.

11. Procédé de décoration selon l'une des revendications 1 à 10, dans lequel le gaz réactif utilisé pour la couche diffusante (11) est de l'oxygène ou de l'azote.

12. Composant horloger tel qu'un cadran, une aiguille, une applique, un pont, une platine, une masse oscillante, un barillet, un fermoir, avec une surface blanche obtenue par le procédé selon l'une des revendications 1 à 11.
